# EUROPÄISCHE PATENTSCHRIFT

(11) **EP 1 486 007 B1**
(45) Veröffentlichungstag und Bekanntmachung des Hinweises auf die Patenterteilung: **19.10.2005**
(21) Anmeldenummer: 03744304.1
(22) Anmeldetag: 17.02.2003
(51) Int. Cl.: H04B 1/30, H03D 7/12, H03D 7/18

(54) **Schaltungsanordnung zur Frequenzverdopplung und Mobilfunkgerät mit der Schaltungsanordnung**
Frequency doubling circuit arrangement and mobile radio set comprising said circuit arrangement
Configuration de circuit pour le doublage de la fréquence et appareil de téléphonie mobile pourvu dudit circuit

(30) Priorität: 15.03.2002 DE 10211523
(43) Veröffentlichungstag der Anmeldung: 15.12.2004
(73) Patentinhaber: Infineon Technologies AG, 81669 München (DE)
(72) Erfinder: GREWING, Christian, 40489 Düsseldorf (DE); HANKE, André, 40489 Düsseldorf (DE); SEIPPEL, Dietolf, 46244 Bottrop (DE)
(74) Vertreter: Epping - Hermann - Fischer
(86) Internationale Anmeldenummer: PCT/DE2003/000477
(87) Internationale Veröffentlichungsnummer: WO 2003/079563

(56) Entgegenhaltungen:
- PATENT ABSTRACTS OF JAPAN vol. 1998, no. 05, 30. April 1998 (1998-04-30) & JP 10 004683 A (NEW JAPAN RADIO CO LTD), 6. Januar 1998 (1998-01-06)
- XIANGDONG ZHANG ET AL: "A DC to X-band frequency doubler using GaAs HBT MMIC" MICROWAVE SYMPOSIUM DIGEST, 1997., IEEE MTT-S INTERNATIONAL DENVER, CO, USA 8-13 JUNE 1997, NEW YORK, NY, USA,IEEE, US, 8. Juni 1997 (1997-06-08), Seiten 1213-1216, XP010228261 ISBN: 0-7803-3814-6

## Beschreibung

Die vorliegende Erfindung betrifft eine Schaltungsanordnung zur Frequenzverdopplung sowie ein Mobilfunkgerät mit der Schaltungsanordnung.

Sowohl in Sende- als auch in Empfangsgeräten des Mobilfunks ist normalerweise eine Frequenzumsetzung zwischen einem Basisband und einem hochfrequenten Funk-Kanal erforderlich. In Sendeanordnungen mit homodyner Architektur beispielsweise wird mittels eines Frequenzmischers ein im Basisband vorliegendes Modulationssignal in eine hochfrequente Lage im Gigahertz-Bereich konvertiert. Hierfür wird eine Trägerfrequenz benötigt, die der gewünschten Sendefrequenz entspricht.

Die Trägerfrequenz wird normalerweise von einem spannungsgesteuerten Oszillator bereitgestellt, der jedoch nicht bei der Sendefrequenz schwingt, sondern auf einer von der Sendefrequenz verschiedenen Frequenz. Diese wird so gewählt, daß sie mit möglichst geringem Aufwand zur Sendefrequenz umgesetzt werden kann. Die Wahl einer anderen Schwingfrequenz als der Sendefrequenz verringert Rückwirkungen der Sendefrequenz auf den Oszillator. Wird die Oszillatorfrequenz geringer als die Sendefrequenz gewählt, kann zusätzlich die Leistungsfähigkeit des spannungsgesteuerten Oszillators verbessert werden. Um eine geringe Stromaufnahme und gute Phasenrauscheigenschaften des Oszillators sicherzustellen, läßt man den Oszillator beispielsweise auf der halben Sendefrequenz schwingen. Demnach ist eine Frequenzverdopplungsschaltung erforderlich, welche die Oszillatorfrequenz auf die gewünschte Trägerfrequenz, die im vorliegenden Beispiel der Sendefrequenz entspricht, übersetzt.

In Analogie hierzu kann auch in Empfangsanordnungen zur Umsetzung einer hochfrequenten Empfangslage in das Basisband oder eine Zwischenfrequenz ein hochfrequentes, sogenanntes Lokaloszillatorsignal mittels einer Frequenzverdopplungsschaltung aus einem Oszillatorsignal bereitgestellt werden.

Die beschriebene Frequenzverdopplung wird normalerweise mittels eines Hochfrequenzmischers bewerkstelligt, mit zwei Eingängen, die beide mit dem Oszillator verbunden sind und eine Quadrierung des Oszillatorsignals am Ausgang des Mischers bewirken. Hierfür wird das Oszillatorsignal mittels eines Phasenschiebers in zwei orthogonal zueinander stehende Signalkomponenten aufgeteilt und auf die gewünschte Sendefrequenz hochgemischt. Am Ausgang des Mischers steht dann aufgrund der beschriebenen Signalquadrierung ein Ausgangssignal mit der doppelten Oszillatorfrequenz bereit. Für die bekannte Frequenzverdopplungsschaltung ist demnach neben einem Hochfrequenzmischer ein Phasenschieber zur Erzeugung orthogonaler Signalkomponenten erforderlich.

In dem Dokument JP 10-004683 A ist eine Gleichrichterschaltung zur Verarbeitung eines single-ended Signals angegeben. Es ist ein Operationsverstärker vorgesehen, der den Ausgang der Schaltung bildet. Der Ausgang ist über Widerstände auf den Eingangsanschluß rückgekoppelt. Außerdem wird ein externes Referenzsignal zugeführt.

Aufgabe der Erfindung ist es, eine Schaltungsanordnung zur Frequenzverdopplung sowie ein Mobilfunkgerät mit der Schaltungsanordnung anzugeben, welche eine Frequenzverdopplung mit geringem Aufwand, geringer Stromaufnahme und guten Rauscheigenschaften ermöglicht.

Erfindungsgemäß wird die Aufgabe bezüglich der Schaltungsanordnung gelöst durch eine Schaltungsanordnung zur Frequenzverdopplung, aufweisend
- ein Eingangsklemmenpaar zum Zuführen eines Eingangssignals mit einer Eingangsfrequenz,
- ein Ausgangsklemmenpaar, an dem ein Ausgangssignal mit der doppelten Eingangsfrequenz abgreifbar ist,
- einen Gleichrichter, der das Eingangsklemmenpaar mit dem Ausgangsklemmenpaar koppelt, zum Gleichrichten des Eingangssignals in Abhängigkeit von einer Referenzgröße und
- eine Regeleinrichtung, die einen Reglereingang hat, der mit dem Ausgangsklemmenpaar gekoppelt ist, und die einen Reglerausgang hat, der mit einem Steuereingang des Gleichrichters zum Zuführen der Referenzgröße gekoppelt ist, ausgebildet zur Regelung der Referenzgröße des Ausgangssignals derart, daß geradzahlige höhere harmonische Frequenzanteile im Spektrum des Ausgangssignals verschwinden oder stark verringert werden, wobei der Gleichrichter so ausgelegt ist, daß mit dem Eingangssignal und mit der Referenzgröße unterschiedliche Transistoren angesteuert werden, die gemeinsam einen Differenzverstärker bilden.

Gemäß vorliegendem Prinzip wird dem Eingangsklemmenpaar ein Eingangssignal mit einer Eingangsfrequenz, beispielsweise mit der Frequenz eines spannungsgesteuerten Oszillators, der am Eingangsklemmenpaar angeschlossen ist, zugeführt. Dieses Signal wird mittels der beschriebenen Schaltungsanordnung bezüglich seiner Frequenz verdoppelt und die verdoppelte Ausgangsfrequenz am Ausgangsklemmenpaar der Schaltungsanordnung bereitgestellt. Der Gleichrichter bewirkt eine Gleichrichtung des Eingangssignals zunächst ohne Glättung und Siebung, aber in Abhängigkeit von einer Bezugsgröße. Dabei werden die unteren Halbwellen des Eingangssignals anschaulich betrachtet nach oben geklappt, so daß bereits nach diesem Gleichrichtungsschritt ein Signal mit doppelter Frequenz an dem Ausgang des Gleichrichters und demnach am Ausgangsklemmenpaar bereitsteht. Dieses würde jedoch höhere harmonische Frequenzanteile aufweisen. Bei einer bevorzugt vorgesehenen Zweiwegegleichrichtung wären im Frequenzspektrum des Ausgangssignals insbesondere geradzahlige höhere harmonische Frequenzanteile dominant. Mittels der Regeleinrichtung, die vom Ausgangsklemmenpaar auf einen Steuereingang des Gleichrichters eingreift, werden diese geradzahligen höheren harmonischen Frequenzanteile im Spektrum des Ausgangssignals dadurch reduziert, daß die Bezugsgröße der Gleichrichtung geregelt wird. Hierfür wird bevorzugt der Gleichanteil des Ausgangssignals, beispielsweise als Gleichtaktsignal, ausgewertet und als Referenzgröße dem Gleichrichter an einem Steuereingang zugeführt.

Bei geeigneter Dimensionierung der Schaltungsanordnung werden die unerwünschten höheren Harmonischen, die auch Oberschwingungen genannt werden, verringert oder ausgelöscht, insbesondere die geradzahligen höheren harmonischen Frequenzanteile im Spektrum des Ausgangssignals. Die Leistungsfähigkeit der Frequenzverdopplung entspricht bei vorliegendem Prinzip dem eingangs erläuterten, welches mit Signalquadrierung des Oszillatorsignals arbeitet. Die Stromaufnahme ist bei vorliegendem Prinzip jedoch um Faktor 3 bis 5 geringer als bei jenem, zudem ist aufgrund des einfachen Aufbaus, der mit wenigen Bauteilen möglich ist, eine Reduzierung der benötigten Chipfläche auf die Hälfte bei Ausführung als integrierte Schaltung ermöglicht.

Das Eingangsklemmenpaar ist bevorzugt ausgelegt zum Zuführen eines Eingangssignal, welches als symmetrisches oder differientielles Spannungssignal vorliegt. Das Ausgangsklemmenpaar ist bevorzugt ausgebildet zum Bereitstellen eines als symmetrisches oder differientielles Stromsignal vorliegenden Signals.

Die Regeleinrichtung ist bevorzugt ausgebildet zur Bereitstellung der Referenzgröße in Abhängigkeit von einem zwischen den beiden Ausgangsklemmen des Ausgangsklemmenpaares abgreifbaren Differenzsignals. Beispielsweise ist die Regeleinrichtung bevorzugt so ausgebildet, daß die Referenzgröße das gleichgerichtete Signal bezüglich einer Darstellung des Signals in einem Schaubild über der Zeit flächengleich teilt.

Die Referenzgröße ist dabei bevorzugt ein DC(Direct Current)-Signal.

Der Gleichrichter ist bevorzugt als Zwei-Weg-Gleichrichter ausgebildet. Zwei-Weg-Gleichrichter weisen gegenüber Ein-Weg-Gleichrichtern den Vorteil auf, daß eine niedrigere Brummspannung und eine höhere Brummfrequenz vorliegen. Dabei bilden die zweite und weitere geradzahlige höhere Harmonische den wesentlichen Anteil der Brummspannung.

Gemäß einer weiteren, bevorzugten Ausführungsform der vorliegenden Erfindung ist eine Stabilisierungseinrichtung zum Stabilisieren der als Gleichsignal vorliegenden Referenzgröße über der Zeit vorgesehen. Die Stabilisierung ist dabei mit dem Reglerausgang und somit auch mit dem Steuereingang des Gleichrichters verbunden.

Der Gleichrichter ist beispielsweise mit zwei Differenzverstärkern aufgebaut, die jeweils ein Transistorpaar mit einem ersten und zweiten Transistor umfassen. Dabei sind die beiden ersten Transistoren bezüglich ihrer gesteuerten Strecken miteinander parallelgeschaltet, ebenso sind die beiden zweiten Transistoren bezüglich ihrer gesteuerten Strecken miteinander parallel geschaltet. Die Steueranschlüsse der beiden ersten Transistoren bilden das Eingangsklemmenpaar der Schaltungsanordnung, während die Steueranschlüsse der beiden zweiten Transistoren miteinander und mit dem Steuereingang des Gleichrichters verbunden sind. Ein derartiger Gleichrichter ist in bipolarer Schaltungstechnik ebenso realisierbar wie im CMOS- oder BICMOS-Schaltungstechnik und zeichnet sich durch geringen Flächenbedarf, geringe Stromaufnahme, sowie einfachen Aufbau aus.

Die Regeleinrichtung ist beispielsweise mit einem Operationsverstärker realisiert, mit einem invertierenden und einem nicht-invertierenden Eingang, welche mit je einer Ausgangsklemme des Ausgangsklemmenpaares der Schaltungsanordnung verbunden sind. Weiterhin weist der Operationsverstärker einen Ausgang auf, der an den Steuereingang des Gleichrichters angeschlossen ist.

Der Operationsverstärker erfaßt den Gleichanteil des Ausgangssignals und speist diesen mit Vorteil als Bezugsgröße der Gleichrichtung in den Gleichrichter ein.

Die Schaltungsanordnung ist bevorzugt ausgelegt zur Verarbeitung eines an den Eingangsklemmen zuführbaren Signals, bei dem der Nutz-Informationsgehalt in der Frequenz des Signals liegt. Dies ist insbesondere bei Mobilfunkgeräten der Fall, bei denen mittels der beschriebenen Frequenzverdopplungsschaltung eine Signalaufbereitung eines Oszillatorsignals erfolgt. Dabei ist es für die Funktionsfähigkeit der Schaltungsanordnung gemäß dem erfinderischen Prinzip unerheblich, ob das Eingangssignal der Frequenzverdopplungsschaltung lediglich ein Trägersignal oder bereits ein moduliertes, hochfrequentes Signal ist.

Bezüglich des Mobilfunkgerätes wird die Aufgabe gelöst durch ein Mobilfunkgerät mit einer Schaltungsanordnung wie vorstehend beschrieben, aufweisend
- zumindest eine Einrichtung zur Frequenzumsetzung zwischen einer hochfrequenten Lage und einem Basisbandsignal mit einem Hilfseingang zum Zuführen eines Signals mit einer Trägerfrequenz,
- einen Frequenzgenerator, der an einem Ausgang ein Bezugssignal mit einer Bezugsfrequenz bereitstellt, und
- die Schaltungsanordnung zur Frequenzverdopplung, die mit ihrem Eingangsklemmenpaar an den Ausgangs des Frequenzgenerators und mit dem Ausgangsklemmenpaar mit dem Hilfseingang der Einrichtung zur Frequenzumsetzung gekoppelt ist.

Insbesondere in Mobilfunkgeräten kommen die Vorteile der vorliegenden Schaltungsanordnung, nämlich deutlich verringerte Stromaufnahme, deutlich verringerte Chipfläche und gute Rauscheigenschaften des frequenzverdoppelten Signals aus offensichtlichen Gründen vorteilhaft zum Tragen.

Zudem ermöglicht eine Frequenzverdopplung zwischen Frequenzgenerator und Frequenzumsetzer eines Nutzsignals einen rückwirkungsfreien Betrieb des Oszillators sowie das Realisieren eines Oszillators mit geringer Stromaufnahme und guten Phasenrauscheigenschaften, unter anderem auf Grund der verringerten Schwingfrequenz.

Weitere Einzelheiten und vorteilhafte Ausgestaltungen des vorliegenden Prinzips ergeben sich aus den Unteransprüchen.

Die Erfindung wird nachfolgend an mehreren Ausführungsbeispielen anhand der Zeichnungen näher erläutert.

Es zeigen:
- Figur 1: ein Ausführungsbeispiel der erfindungsgemäßen Schaltungsanordnung anhand eines vereinfachten Schaltbildes und
- Figur 2: ein Mobilfunkgerät mit einer Schaltungsanordnung gemäß Figur 1.

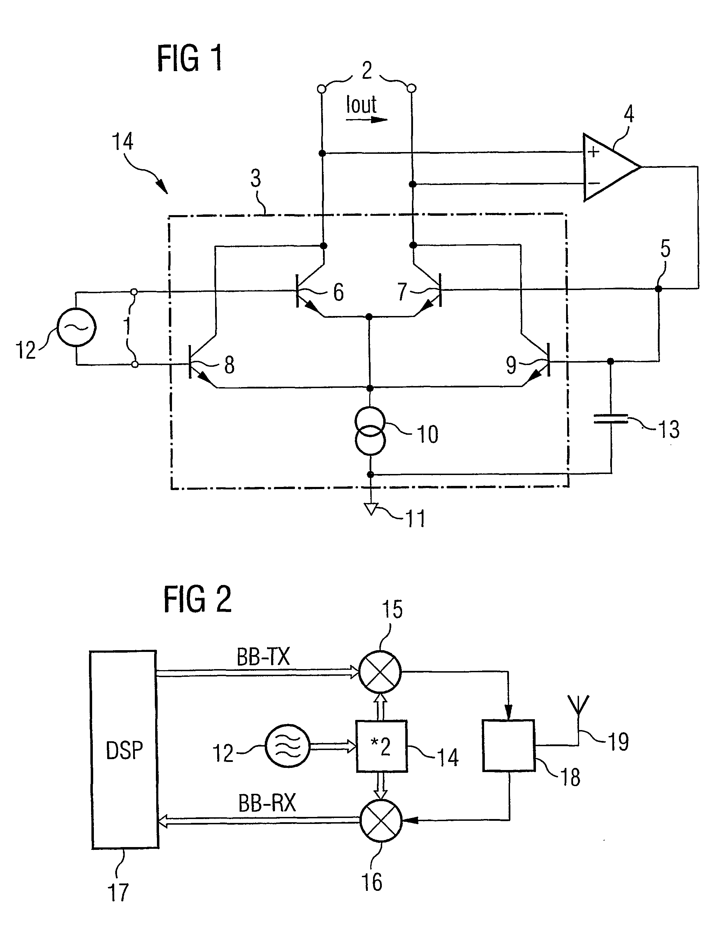

Figur 1 zeigt eine Schaltungsanordnung zur Frequenzverdopplung. Dabei ist zwischen ein Eingangsklemmenpaar 1 zum Zuführen eines Eingangssignals mit einer Eingangsfrequenz und ein Ausgangsklemmenpaar 2, an dem ein Ausgangssignal mit der doppelten Eingangsfrequenz abgreifbar ist, ein Gleichrichter 3 geschaltet. Der Gleichrichter 3 ist zum Gleichrichten des Eingangssignals in Abhängigkeit von einer Referenzgröße ausgebildet. Zur Bereitstellung dieser Referenzgröße ist eine Regeleinrichtung 4 vorgesehen, die einen Reglereingang hat, der mit dem Ausgangsklemmenpaar 2 gekoppelt ist und deren Ausgang mit einem Steuereingang 5 des Gleichrichters 3 zum Zuführen der Referenzgröße gekoppelt ist. Eingangsklemmenpaar 1 und Ausgangsklemmenpaar 2 sind jeweils symmetrisch zum Führen differentieller Signale ausgebildet. Der Regler 4 ist als Operationsverstärker ausgebildet mit einem nicht-invertierenden Eingang und einem invertierenden Eingang, die mit je einer Anschlußklemme des Ausgangsklemmenpaars 2 verbunden sind. Der Gleichrichter 3 selbst umfaßt zwei Differenzverstärker, welche jeweils ein Paar von emittergekoppelten Transistoren 6, 7; 8, 9 umfassen. Jeder Differenzverstärker umfaßt je einen ersten Transistor 6, 8 und einen zweiten Transistor 7, 9. Die NPN-Bipolartransistoren 6, 7 des ersten Differenzverstärkers sind mit ihren Emitteranschlüssen miteinander und über eine Speisestromquelle 10 mit einem Bezugspotentialanschluß 11 gekoppelt. Die NPN-Bipolartransistoren des zweiten Differenzverstärkers 8, 9 sind mit ihren gemeinsamen Emitteranschlüssen mit den Emitteranschlüssen des ersten Differenzverstärkers 6, 7 verbunden. Kollektorseitig sind jeweils die ersten Transistoren 6, 8 der beiden Differenzverstärker miteinander und mit einer Ausgangsklemme des Ausgangsklemmenpaares 2 verbunden; ebenso sind die Kollektoranschlüsse der zweiten Transistoren 7, 9 der beiden Differenzverstärker miteinander und dem weiteren Ausgangsklemmenanschluß des Ausgangsklemmenpaares 2 verbunden. Die beiden Basis-Anschlüsse der ersten Transistoren 6, 8 bilden das symmetrische Eingangsklemmenpaar 1. An das Eingangsklemmenpaar 1 ist ein Oszillator 12 angeschlossen, welcher das Eingangssignal mit der Eingangsfrequenz abgibt. Der Steuereingang 5 des Gleichrichters 3 ist mit den Basisanschlüssen der zweiten Transistoren 7, 9 der Differenzverstärker verbunden und weiterhin über eine Stabilisierungskapazität 13 gegen Bezugspotentialanschluß 11 geschaltet.

Mit dem Gleichrichter 3 wird ein am Eingang 1 anliegendes, sogenanntes differentielles Eingangssignal zunächst gleichgerichtet. Der beschriebene Gleichrichter arbeitet dabei als Zweipunkt-Gleichrichter. Die bei Zweipunkt-Gleichrichtung normalerweise entstehenden zweiten und weiteren geradzahligen höheren Harmonischen werden mittels des Reglers 4 weitgehend unterdrückt. Dies erfolgt dadurch, daß der Regler 4 das Bezugspotential, welches dem Gleichrichter 3 an seinem Steuereingang 5 zugeführt wird, in Abhängigkeit vom am Ausgang anliegenden Ausgangssignal nachregelt. Am Ausgang des Gleichrichters 3, also am Ausgang 2 der Schaltungsanordnung, liegt das Signal mit verdoppelter Frequenz des Eingangssignals als differentielles oder symmetrisches Signal vor.

Gegenüber herkömmlichen, mit Signalquadrierung arbeitenden Frequenzverdopplerschaltungen benötigt die vorliegende Frequenz-Verdopplungsschaltung einen um den Faktor 3 bis 5 verringerten Arbeitsstrom und kann auf halber Chipfläche integriert werden.

Figur 2 zeigt ein Mobilfunkgerät mit der Schaltungsanordnung zur Frequenzverdopplung von Figur 1, die dort mit Bezugszeichen 14 versehen ist. Dabei ist ein Aufwärts-Frequenzmischer 15 in einem Sendepfad, sowie ein Abwärts-Frequenzmischer 16 in einem Empfangspfad des Mobilfunkgerätes vorgesehen. Der Aufwärts-Frequenzumsetzer 15 weist einen Modulationseingang zum Zuführen eines im Basisband vorliegenden Modulationssignals BB-TX auf und ist mit einem digitalen Signalprozessor 17 gekoppelt, der das Modulationssignal im Basisband bereitstellt. Am Ausgang des Aufwärts-Frequenzumsetzers 15 steht das Modulationssignal als in eine hochfrequente Lage konvertierter, modulierter Träger bereit. Der Ausgang des Aufwärts-Frequenzmischers 15 ist mit einer Duplexeinheit 18 gekoppelt, welche wiederum bidirektional an eine Antenne 19 angeschlossen ist. Die Duplexeinheit 18 ist weiterhin in Empfangsrichtung an einem Ausgang an einen Hochfrequenzeingang des Abwärts-Frequenzmischers 16 zum Zuführen eines hochfrequenten Empfangssignals angeschlossen. Der Ausgang des Abwärts-Frequenzmischers 16 ist mit einem Eingang des digitalen Signalprozessors 17 verbunden, dem dabei ein demoduliertes, ins Basisband heruntergemischtes Empfangssignal zugeführt wird. Zur Ansteuerung der Frequenz-Mischer 15, 16 mit einem Trägersignal ist ein spannungsgesteuerter Oszillator 12, der auch eine Phasenregelschleife umfassen kann, vorgesehen. Dieser spannungsgesteuerte Oszillator 12 ist über die Schaltungsanordnung zur Frequenzverdopplung 14 an je einen Hilfseingang der Mischer 15, 16 angeschlossen. Demnach wird die Schwingfrequenz des Oszillators 12 den Hilfseingängen der Mischer 15, 16 verdoppelt zugeführt.

Insbesondere bei mobilen Anwendungen sind die Eigenschaften der vorliegenden Frequenzverdopplungseinheit, wie geringe Stromaufnahme und geringe Chipfläche, von besonderer Bedeutung. Der Oszillator 12 kann bei halber Schwingfrequenz arbeiten, so daß eine weitere Vereinfachung des Schaltungslayouts gewährleistet ist.

Anstelle der gezeigten Direktumsetzungsarchitektur des Mobilfunkgerätes können, insbesondere in Bezug auf den Empfangszweig des Transceivers gemäß Figur 2, auch heterodyne Architekturen sowie Low-IF-Architekturen vorteilhaft mit der erfindungsgemäßen Frequenzverdopplungsschaltung ausgestattet sein.

### Bezugszeichenliste

- 1: Eingangsklemmenpaar
- 2: Ausgangsklemmenpaar
- 3: Gleichrichter
- 4: Regeleinrichtung
- 5: Steuereingang
- 6: erster Transistor
- 7: zweiter Transistor
- 8: erster Transistor
- 9: zweiter Transistor
- 10: Stromquelle
- 11: Bezugspotentialanschluß
- 12: Oszillator
- 13: Kondensator
- 14: Frequenzverdopplungsschaltung
- 15: Aufwärts-Frequenzumsetzer
- 16: Abwärts-Frequenzumsetzer
- 17: digitaler Signalprozessor
- 18: Duplexeinheit
- 19: Antenne

## Patentansprüche

1. Schaltungsanordnung zur Frequenzverdopplung, aufweisend
- ein Eingangsklemmenpaar (1) zum Zuführen eines Eingangssignals mit einer Eingangsfrequenz,
- ein Ausgangsklemmenpaar (2), an dem ein Ausgangssignal mit der doppelten Eingangsfrequenz abgreifbar ist,
- einen Gleichrichter (3), der das Eingangsklemmenpaar (1) mit dem Ausgangsklemmenpaar (2) koppelt, zum Gleichrichten des Eingangssignals in Abhängigkeit von einer Referenzgröße und
- eine Regeleinrichtung (4), die einen Reglereingang hat, der mit dem Ausgangsklemmenpaar (2) gekoppelt ist, und die einen Reglerausgang hat, der mit einem Steuereingang (5) des Gleichrichters (3) zum Zuführen der Referenzgröße gekoppelt ist, ausgebildet zur Regelung der Referenzgröße des Ausgangssignals **durch** Erfassung des Gleichanteils des Ausgangssignals, wobei der Gleichrichter (3) so ausgelegt ist, daß mit dem Eingangssignal und mit der Referenzgröße unterschiedliche Transistoren (6,7) angesteuert werden, die gemeinsam einen Differenzverstärker bilden.

2. Schaltungsanordnung nach Anspruch 1, wobei
die Regeleinrichtung (4) ausgebildet ist zur Bereitstellung der Referenzgröße in Abhängigkeit von einem zwischen den beiden Ausgangsklemmen des Ausgangsklemmenpaares (2) abgreifbaren Differenzsignal.

3. Schaltungsanordnung nach Anspruch 1 oder 2, wobei
der Gleichrichter (3) als Zweiweggleichrichter ausgebildet ist.

4. Schaltungsanordnung nach einem der Ansprüche 1 bis 3,
wobei
eine Stabilisierungseinrichtung (13) zum Stabilisieren der als Gleichsignal vorliegenden Referenzgröße über der Zeit vorgesehen ist, die mit dem Reglerausgang verbunden ist.

5. Schaltungsanordnung nach einem der Ansprüche 1 bis 4, wobei
- der Gleichrichter (3) zwei jeweils als Differenzverstärker verschaltete Transistorpaare (6, 7; 8, 9) aufweist, die jeweils einen ersten Transistor (6, 8) und einen zweiten Transistor (7, 9) umfassen,
- die beiden ersten Transistoren (6, 8) bezüglich ihrer gesteuerten Strecken miteinander parallelgeschaltet sind,
- die beiden zweiten Transistoren (7, 9) bezüglich ihrer gesteuerten Strecken miteinander parallelgeschaltet sind,
- das Eingangsklemmenpaar (1) der Schaltungsanordnung mit den beiden Steueranschlüssen der ersten Transistoren (6, 8) verbunden ist und
- der Steuereingang (5) des Gleichrichters (3) mit den beiden Steueranschlüssen der zweiten Transistoren (7, 9) verbunden ist.

6. Schaltungsanordnung nach einem der Ansprüche 1 bis 5,
wobei die Regeleinrichtung (4) einen Operationsverstärker umfaßt, mit zwei Eingängen, die mit dem Ausgangsklemmenpaar (2) der Schaltungsanordnung verbunden sind, und mit einem Ausgang, der an den Steuereingang (5) des Gleichrichters (3) angeschlossen ist.

7. Schaltungsanordnung nach einem der Ansprüche 1 bis 6,
wobei die Schaltungsanordnung ausgelegt ist zur Verarbeitung eines an den Eingangsklemmen (1) zuführbaren Signals, bei dem der Nutz-Informationsgehalt in der Frequenz des Signals liegt.

8. Mobilfunkgerät mit einer Schaltungsanordnung mit den Merkmalen gemäß einem der Ansprüche 1 bis 7, aufweisend
- zumindest eine Einrichtung zur Frequenzumsetzung (15, 16) zwischen einer hochfrequenten Lage und einem Basisbandsignal mit einem Hilfseingang zum Zuführen eines Signals mit einer Trägerfrequenz,
- einen Frequenzgenerator (12), der an einem Ausgang ein Bezugssignal mit einer Bezugsfrequenz bereitstellt, und
- die Schaltungsanordnung zur Frequenzverdopplung (14), die mit ihrem Eingangsklemmenpaar (1) an den Ausgang des Frequenzgenerators (12) und mit dem Ausgangsklemmenpaar (2) mit dem Hilfseingang der zumindest einen Einrichtung zur Frequenzumsetzung (15, 16) gekoppelt ist.

## Claims

1. A frequency-doubling circuit arrangement having
- an input terminal pair (1) for supplying an input signal at an input frequency,
- an output terminal pair (2) from which an output signal at twice the input frequency can be tapped off,
- a rectifier (3) which couples the input terminal pair (1) to the output terminal pair (2) and is intended to rectify the input signal as a function of a reference variable, and
- a regulating device (4) having a regulator input which is coupled to the output terminal pair (2) and having a regulator output which is coupled to a control input (5) of the rectifier (3) for the purpose of supplying the reference variable, said regulating device being designed to regulate the reference variable of the output signal by detecting the DC component of the output signal, with the rectifier (3) being designed in such a manner that the input signal and the reference variable are used to drive different transistors (6, 7) which together form a differential amplifier.

2. The circuit arrangement as claimed in claim 1,
wherein
the regulating device (4) is designed to provide the reference variable as a function of a difference signal which can be tapped off between the two output terminals of the output terminal pair (2).

3. The circuit arrangement as claimed in claim 1 or 2,
wherein
the rectifier (3) is in the form of a full-wave rectifier.

4. The circuit arrangement as claimed in one of claims 1 to 3,
wherein
a stabilizing device (13) which is connected to the regulator output is provided for the purpose of stabilizing the reference variable, which is in the form of a DC signal, over the course of time.

5. The circuit arrangement as claimed in one of claims 1 to 4,
wherein
- the rectifier (3) has two transistor pairs (6, 7; 8, 9) which are each connected as differential amplifiers and each comprise a first transistor (6, 8) and a second transistor (7, 9),
- the controlled paths of the two first transistors (6, 8) are connected in parallel with one another,
- the controlled paths of the two second transistors (7, 9) are connected in parallel with one another,
- the input terminal pair (1) of the circuit arrangement is connected to the two control connections of the first transistors (6, 8), and
- the control input (5) of the rectifier (3) is connected to the two control connections of the second transistors (7, 9).

6. The circuit arrangement as claimed in one of claims 1 to 5,
wherein
the regulating device (4) comprises an operational amplifier having two inputs which are connected to the output terminal pair (2) of the circuit arrangement and having an output which is connected to the control input (5) of the rectifier (3).

7. The circuit arrangement as claimed in one of claims 1 to 6,
wherein
the circuit arrangement is designed to process a signal which can be supplied to the input terminals (1) and whose frequency contains the useful information.

8. A mobile radio having a circuit arrangement with the features claimed in one of claims 1 to 7, having
- at least one device for frequency conversion (15, 16) between a radio frequency and a baseband signal, said device having an auxiliary input for supplying a signal at a carrier frequency,
- a frequency generator (12) which provides a reference signal at a reference frequency at an output, and
- the frequency-doubling circuit arrangement (14) whose input terminal pair (1) is coupled to the output of the frequency generator (12) and whose output terminal pair (2) is coupled to the auxiliary input of the at least one device for frequency conversion (15, 16).

## Revendications

1. Configuration de circuit pour le doublement de la fréquence comprenant
- une paire (1) de bornes d'entrée pour l'amenée d'un signal d'entrée ayant une fréquence d'entrée ;
- une paire (2) de bornes de sortie à laquelle un signal de sortie ayant le double de la fréquence d'entrée peut être prélevé ;
- un redresseur (3) qui couple la paire (1) de bornes d'entrée à la paire (2) de bornes de sortie pour redresser le signal d'entrée en fonction d'une grandeur de référence ; et
- un dispositif (4) de régulation qui a une entrée de régulation couplée à la paire (2) de bornes de sortie et une sortie de régulation couplée à une entrée (5) de commande du redresseur (3) pour amener la grandeur de référence et qui est constitué pour réguler la grandeur de référence du signal de sortie par détection de la partie continue du signal de sortie, le redresseur (3) étant tel que des transistors (6, 7) différents, qui forment ensemble un amplificateur différentiel, sont commandés par le signal d'entrée et par la grandeur de référence.

2. Configuration de circuit suivant la revendication 1, dans lequel le dispositif (4) de régulation est constitué pour mettre à disposition la grandeur de référence en fonction d'un signal de différence pouvant être prélevé entre les deux bornes de sortie de la paire (2) de bornes de sortie.

3. Configuration de circuit suivant la revendication 1 ou 2, dans lequel le redresseur (3) est constitué en redresseur biphasé.

4. Configuration de circuit suivant l'une des revendications 1 à 3, dans lequel il est prévu un dispositif (13) de stabilisation en fonction du temps de la grandeur de référence se présentant sous la forme d'un signal continu, ce dispositif de stabilisation étant relié à la sortie du dispositif de régulation.

5. Configuration de circuit suivant l'une des revendications 1 à 4, dans lequel
- le redresseur (3) a deux paires (6, 7, 8, 9) de transistors montés, respectivement, en amplificateurs différentiels qui comprennent, respectivement, un premier transistor (6, 8) et un deuxième transistor (7, 9) ;
- les deux premiers transistors (6, 8) sont montés en parallèle entre eux pour ce qui concerne leur section commandée ;
- les deux deuxièmes transistors (7, 9) sont montés en parallèle entre eux pour ce qui concerne leur section commandée ;
- la paire (1) de bornes d'entrée de la configuration de circuit est reliée aux deux bornes de commande des premiers transistors (6, 8) ; et
- l'entrée (5) de commande du redresseur (3) est reliée aux deux bornes de commande des deuxièmes transistors (7, 9).

6. Configuration de circuit suivant l'une des revendications 1 à 5, dans lequel le dispositif (4) de régulation comprend un amplificateur opérationnel ayant deux entrées qui sont reliées à la paire (2) de bornes de sortie de la configuration de circuit et ayant une sortie qui est reliée au dispositif (5) de commande du redresseur (3).

7. Configuration de circuit suivant l'une des revendications 1 à 6, dans lequel la configuration de circuit est conçue pour le traitement d'un signal pouvant être amené aux bornes (1) d'entrée, la teneur en informations utiles se trouvant dans la fréquence du signal.

8. Appareil de téléphonie mobile ayant une configuration de circuit comportant les caractéristiques suivant l'une des revendications 1 à 7, et comprenant
- au moins un dispositif de conversion de fréquence (15, 16) entre une position de haute fréquence et un signal de bande de base ayant une entrée auxiliaire pour amener un signal ayant une fréquence porteuse ;
- un générateur (12) de fréquence qui met à disposition sur une sortie un signal de référence signant une fréquence de référence ; et
- la configuration de circuit pour le doublement de la fréquence (14) qui est couplée par sa paire (1) de bornes d'entrée à la sortie du générateur (12) de fréquence et par la paire (2) de bornes de sortie à l'entrée auxiliaire du au moins un dispositif de conversion de la fréquence (15, 16).
